# EUROPÄISCHE PATENTSCHRIFT

(11) **EP 1 042 789 B1**
(45) Veröffentlichungstag und Bekanntmachung des Hinweises auf die Patenterteilung: **18.06.2003**
(21) Anmeldenummer: 98961220.5
(22) Anmeldetag: 18.11.1998
(51) Int. Cl.: H01L 21/00

(54) **Verfahren zum Behandeln von Substraten**
Method for Treating Substrates
Procédé destinté au Traitment de Substrats

(30) Priorität: 31.12.1997 DE 19758267
(43) Veröffentlichungstag der Anmeldung: 11.10.2000
(73) Patentinhaber: STEAG MicroTech GmbH, 72124 Pliezhausen (DE)
(72) Erfinder: OSHINOWO, John, D-22850 Norderstedt (DE)
(74) Vertreter: Wagner, Karl H., Dipl.-Ing.
(86) Internationale Anmeldenummer: EP9807405
(87) Internationale Veröffentlichungsnummer: WO99035672

(56) Entgegenhaltungen:
- WO-A-95/02473
- DE-A- 19 722 423
- US-A- 5 133 376
- PATENT ABSTRACTS OF JAPAN vol. 017, no. 025 (C-1017), 18. Januar 1993 -& JP 04 247276 A (FUJITSU LTD), 3. September 1992

## Beschreibung

Die Erfindung gemäß dem Anspruch 1 betrifft ein Verfahren zum Behandeln von Substraten in einem Fluidbehälter mit wenigstens einem Fluid und mit Ultraschall, wobei gegenüberliegende Behälterwände jeweils wenigstens zwei Ultraschall-Abstrahlelmente aufweisen, die jeweils einzeln angesteuert werden .

Vorrichtungen sind beispielsweise aus der WO 95/02473 oder aus der auf diesselbe Anmelderin zurückgehenden DE 197 22 423 bekannt. Bei diesen Vorrichtungen sind die Substrate während der Behandlung im Fluidbehälter angeordnet, und es werden Behandlungsflüssigkeiten über eine Einlaßöffnung in den Fluidbehälter eingeleitet.

Gleichzeitig oder nach der Behandlung mit dem Fluid werden die Substrate mit Ultraschall beschallt, um den Reinigungsvorgang zu verbessern und zu beschleunigen. Hierbei ist es wichtig, daß die Substrate gleichmäßig beschallt werden, um eine gleichmäßige Reinigungswirkung zu erzeugen. Diese gleichmäßige Beschallung der Substrate ist bei den bekannten Vorrichtungen jedoch nicht möglich, weil Beschallungskegel unterschiedliche Beschallungsintensitäten erzeugen oder gar Totwinkel auftreten. Bei der aus der WO 95/02473 bekannten Vorrichtung sind Ultraschall-Abstrahlvorrichtungen an gegenüberliegenden Seitenwänden vorgesehen. Die Ultraschall-Abstrahlvorrichtungen werden durch sich horizontal erstreckende Ultraschall-Streifen gebildet. Um eine gleichmäßigere Beschallung der Substrate zu erreichen, sind Führungseinrichtungen für die Substrate auf den Innenflächen der Seitenwände des Fluidbehälters sowie die Ultraschall-Abstrahlbereiche versetzt angeordnet. Damit ist eine Verbesserung hinsichtlich einer gleichmäßigen Bestrahlung der Substrate nur in begrenztem Maße möglich, weil diese Führungseinrichtungen, die den Ultraschall-Abstrahlbereichen gegenüberliegen, aufgrund der dadurch eintretenden Dämpfung andere Beschallungsintensitäten hervorrufen, als dies außerhalb der Bereiche der Fall ist, in denen die Führungseinrichtungen nicht vorhanden sind. Ferner besteht bei dieser Anordnung das Problem, daß bei der Beschallung der Substrate von den gegenüberliegenden Seitenwänden aus, Wechselwirkungen und Wellenauslöschungen, insbesondere bei den aufeinander zulaufenden Ultraschallwellen entstehen, wodurch eine gleichmäßige Beschallung der Substrate und somit eine gleichmäßige Reinigungswirkung nicht oder nur beschränkt möglich ist.

Aus der US 4 909 266 ist eine Vorrichtung zum Behandeln von Substraten mit Ultraschall bekannt, bei der die Ultraschallwellen selektiv und kurzzeitig abgestrahlt werden, um dadurch die Reinigungswirkung zu erhöhen. Diese Vorrichtung verhindert nicht, daß die zuvor beschriebenen Wechselwirkungen und Wellenauslöschungen auftreten, die eine gleichmäßige Reinigungswirkung verhindern.

Aus der JP 9-199 464 A (Abstract) ist eine Vorrichtung mit Gruppen von Ultraschall-Abstrahlbereichen mit unterschiedlichen Frequenzen bekannt, um Partikel mit unterschiedlichen Größen von einem zu reinigendem Substrat zu entfernen. Auch diese Vorrichtung weist den Nachteil auf, daß sich keine gleichmäßigen Reinigungswirkungen ergeben, weil sich hierbei wiederum die Ultraschallwellen in Wechselwirkung bzw. Auslöschung befinden.

Der Erfindung liegt die Aufgabe zugrunde, ein Verfahren zur Behandlung von Substraten anzugeben, das eine gleichmäßigere und intensivere Behandlung der Substratflächen mit Ultraschall ermöglicht.

Die gestellte Aufgabe wird erfindungsgemäß dadurch gelöst, daß die Ultraschall-Abstrahlelemente einer Behälterwand in zeitlicher Beziehung zu den Ultraschall-Abstrahlelementen der anderen Behälterwand derart angesteuert werden, daß einander gegenüberliegende Ultraschall-Abstrahlelemente nicht gleichzeitig angesteuert werden. Diese zeitlich versetzte Ansteuerung der Ultraschall-Abstrahlelemente vermeidet, daß Wechselwirkungen, Interferenzen und/oder Auslöschungen zwischen bzw. von Ultraschallwellen auftreten, die von gegenüberliegenden Ultraschall-Abstrahlelementen abgestrahlt werden. Hierdurch wird eine über die gesamten Substratflächen hinweg gleichmäßige, gute und intensive Behandlung der Substrate mit Ultraschall gewährleistet.

Vorzugsweise werden die Ultraschall-Abstrahlelemente einer Behälterwand zeitlich versetzt angesteuert, wodurch die oben genannten Wechselwirkungen noch weiter reduziert werden. Gemäß einer bevorzugten Ausführungsform wird jeder n-te Ultraschall-Abstrahlelement einer Behälterwand, beispielsweise bei n=3 also der 1., 4. und 7. und/oder der 2., 5, und 8. usw., gleichzeitig angesteuert, wodurch erreicht wird, daß mehrere bzw. eine Gruppe von Abstrahlelementen angesteuert wird, so daß im Gegensatz zu einer jeweils einzelnen zeitlich versetzten Ansteuerung die Bearbeitungsgeschwindigkeit erhöht werden kann, ohne daB jedoch die oben genannten nachteiligen Wechselwirkungen auftreten.

Vorteilhafterweise werden die Substrate während des Behandlungsvorgangs relativ bezüglich der Ultraschall-Abstrahlelemente bewegt, insbesondere angehoben und abgesenkt, um eine homogenere Behandlung der Substrate über die Substratflächen hinweg zu ermöglichen.

Gemäß einer besonders bevorzugten Ausführungsform sind die einzelnen Ultraschall-Abstrahlelemente einer Behälterwand räumlich versetzt zu den Ultraschall-Abstrahlelemente der anderen Behälterwand angeordnet, um zu verhindern, daß Bereiche entstehen, in denen keine Ultraschall-Behandlung auftritt, da die Abstrahlelemente der gegenüberliegenden Behälterwände einander überlappen.

Vorteilhafterweise sind die Ultraschall-Abstrahlelemente streifenförmig und entweder vertikal oder horizontal, angeordnet.

Die Erfindung wird nachstehend anhand vorteilhafter Ausführungsformen unter Bezugnahme auf die Figuren erläutert. Es zeigen:
- Fig. 1: eine schematische Darstellung einer Vorrichtung mit Ultraschall-Abstrahlelemente auf gegenüberliegenden Wänden eines Fluidbehälters;
- Fig. 2: eine Draufsicht auf die Vorrichtung.
- Fig. 3A und B: schematisch den Aufbau einer Ausführungsform von Ultraschall-Abstrahlelemente auf gegenüberliegenden Wänden des Fluidbehälters;

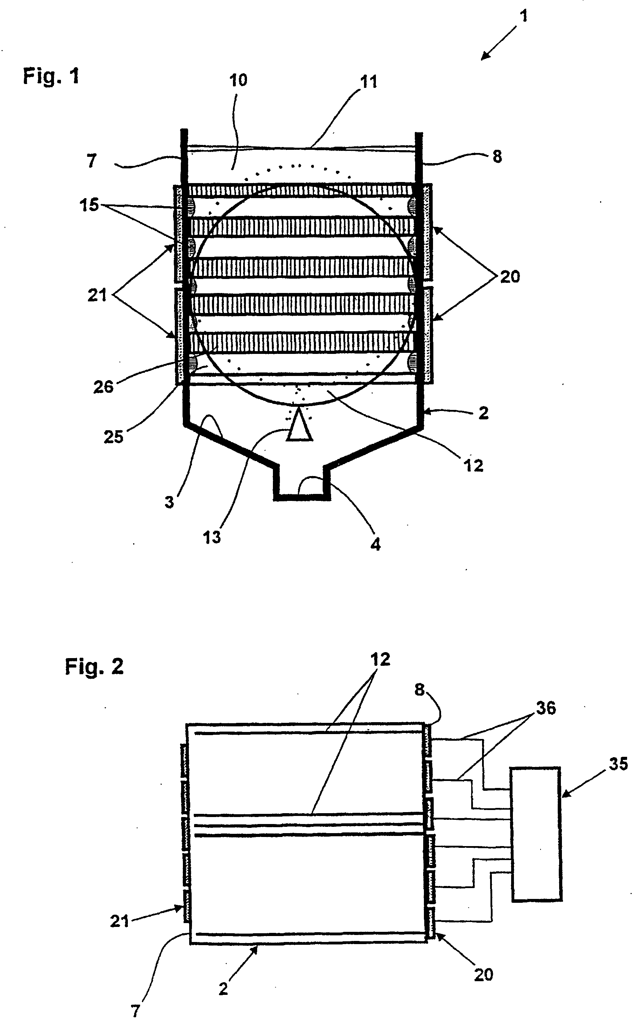

Fig. 1 zeigt im Querschnitt eine Vorrichtung 1 zum Behandeln von Substraten. Die Vorrichtung 1 weist einen Fluidbehälter 2 mit einem eine Vertiefung 4 enthaltenden Behälterboden 3 und mit Behälterseitenwänden 7 und 8 auf. Im Fluidbehälter 2 befindet sich ein Behandlungsfluid 10 mit einer Fluidoberfläche 11, sowie Substrate 12, beispielsweise Wafer, die in Blickrichtung hintereinander parallel zueinander ausgerichtet sind. Die Substrate 12 liegen mit einem Kantenbereich auf einer Substrataufnahmevorrichtung 13 auf, die im vorliegenden Ausführungsbeispiel als ein sogenanntes Messer ausgebildet ist.

Da die Substrataufnahmevorrichtung 13 im vorliegenden Ausführungsbeispiel die Substrate 12 nicht allein halten oder parallel zueinander ausgerichtet fixieren kann, sind an den Innenflächen der Seitenwände 7, 8 des Fluidbehälters 2 Führungen 15 für die Wafer 12 vorgesehen, die bei dem dargestellten Ausführungsbeispiel in Form von geschlitzten Stegen ausgebildet sind, die sich senkrecht zu den Waferflächen erstrecken. Die Führungen 15 befinden sich auf den beiden gegenüberliegenden Behälterwänden 7, 8 jeweils in derselben Höhe.

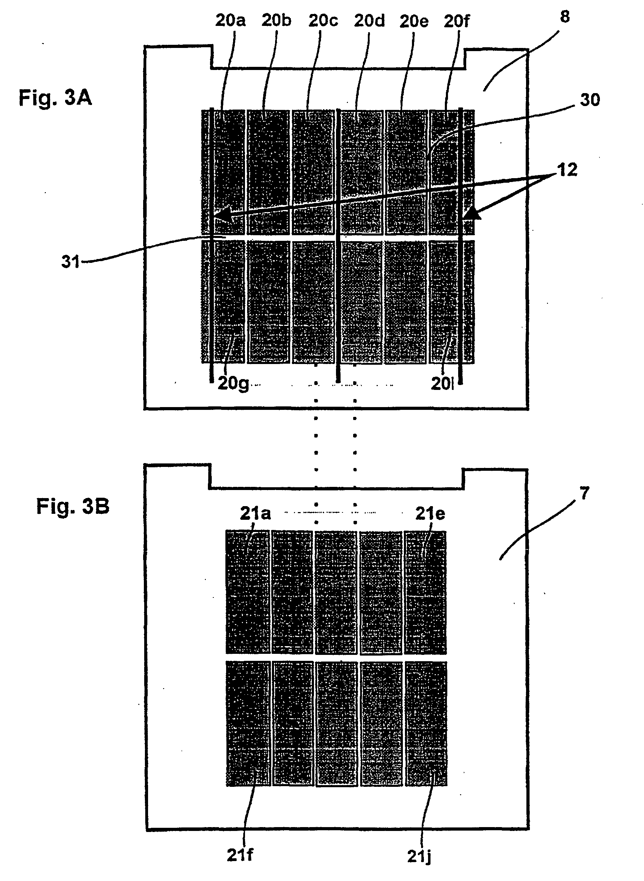

Bei dem dargestellten Ausführungsbeispiel sind an den Behälterwänden 7, 8 Ultraschall-Abstrahlvorrichtungen 20 bzw. 21 angebracht, die über die Behälterwände Ultraschall, vorzugsweise Megaschall beispielsweise in einem Frequenzbereich von 900 bis 1100 KHz, in Richtung der Substrate 12 abstrahlen. Der Aufbau der Ultraschall-Abstrahlvorrichtungen 20 bzw. 21 wird nachfolgend anhand der Fig. 2 und 3 näher erläutert. Aufgrund der einander gegenüberliegenden Führungen 15 treten waagerechte Bereiche 25 und 26 auf, wobei in den Bereichen 25 gegenüber den Bereichen 26 nur eine geringere Bestrahlung der Substrate 12 möglich ist.

Durch das Messer 13 ist es möglich, die Substrate 12 während der Ultraschall-Behandlung anzuheben und abzusenken, damit sich die Substrate relativ zu den Bereichen 25 und 26 bewegen, um eine gleichmäßige Beschallung der Substrate 12 zu bewirken.

Anhand der Fig. 2 und 3 wird nunmehr der Aufbau der Ultraschall-Abstrahlvorrichtungen 20 bzw. 21 näher erläutert. Wie zu erkennen ist, werden die Ultraschall-Abstrahlvorrichtungen jeweils durch streifenförmige Ultraschall-Abstrahlelemente gebildet, die von außen an die jeweilige Behälterwand 8 bzw. 7 angebracht, vorzugsweise aufgeklebt sind. Streifenförmige Ultraschall-Abstrahlelemente sind bekannt und werden daher nicht näher beschrieben.

Bei dem dargestellten Ausführungsbeispiel sind auf der rechten Behälterwand 8 zwölf streifenförmige Ultraschall-Abstrahlelemente 20a bis 201 angebracht, die eine dementsprechende Anzahl von Ultraschall-Abstrahlbereichen definieren. Die streifenförmigen Ultraschall-Abstrahlelemente 20a bis 20f sind parallel zueinander an einer oberen Hälfte der Behälterwand 8 angebracht, wobei zwischen den parallelen Elementen jeweils kleine Freiräume 30 entstehen. Direkt unterhalb der Anordnung von Ultraschall-Abstrahlelementen 20a bis 20f sind wiederum in paralleler Ausrichtung zueinander streifenförmige Ultraschall-Abstrahlelemente 20g bis 20l angebracht. Zwischen den oberen Ultraschall-Abstrahlelementen 20a bis 20f und den unteren Abstrahlelementen 20g bis 20l wird ein Freiraum 31 gebildet.

Auf der gegenüberliegenden Behälterwand 7 sind in ähnlicher Weise Ultraschall-Abstrahlelemente angebracht. Auf der Behälterwand 7 sind jedoch nur zehn Ultraschall-Abstrahlelemente 21a bis 21j angebracht, vorzugsweise geklebt, wobei die Ultraschall-Abstrahlelemente 21a bis 21e eine erste obere Reihe und die Ultraschall-Abstrahlelemente 21f bis 21j eine direkt unter der ersten Reihe liegende zweite Reihe von Ultraschall-Abstrahlelementen bilden. Die auf der Behälterwand 7 angebrachten Ultraschall-Abstrahlelemente 21a bis 21j sind derart angeordnet, daß die Zwischenräume 30 zwischen den Ultraschall-Abstrahlelementen 20a bis 20f bzw. 20g bis 20l der gegenüberliegenden Behälterwand 8 abdecken und jeweils zwei benachbarte der Ultraschall-Abstrahlelemente der gegenüberliegenden Behälterwand 8 teilweise überlappen. Diese räumliche Beziehung zwischen den jeweiligen Ultraschall-Abstrahlelementen an den Seitenwänden 7 und 8 ist besonders gut in den Fig. 3A und B zu erkennen.

Die Ultraschall-Abstrahlelemente 20a bis 20l können jeweils einzeln über eine in Fig. 2 schematisch dargestellte Ansteuerschaltung 35, die jeweils über Zuleitungen 36 mit den jeweiligen Ultraschall-Abstrahlelementen verbunden ist, angesteuert werden. In gleicher Weise können die Ultraschall-Abstrahlelemente 21a bis 21j auf der Behälterwand 7 jeweils einzeln angesteuert werden, wobei dies entweder über eine nicht dargestellte zweite Ansteuerschaltung oder über die in Fig. 2 dargestellte Ansteuerschaltung 35 erfolgt.

Bei der Behandlung der in dem Behälter 2 befindlichen Substrate 12 werden die Ultraschall-Abstrahlelemente auf den gegenüberliegenden Seitenwänden 7 und 8 jeweils einzeln angesteuert, und zwar derart, daß Wechselwirkungen, insbesondere Wellenauslöschungen oder stehende Wellen, vermieden werden. Dies geschieht insbesondere dadurch, daß die einzelnen Ultraschall-Abstrahlelemente zu unterschiedlichen Zeiten angesteuert bzw. gepulst betrieben werden. Dabei können wegen einer nur geringen Gefahr von Wechselwirkungen übereinanderliegende Ultraschall-Abstrahlelemente, z. B. die Elemente 20a, 20g, gleichzeitig angesteuert bzw. als ein Element behandelt werden. Ferner kann aufgrund der räumlichen Entfernung jedes n-te Ultraschall-Abstrahlelement sowie ihre darunterliegenden Ultraschall-Abstrahlelemente gleichzeitig angesteuert werden (wobei n≥2), so daß jeweils wenigstens ein Ultraschall-Abstrahlelement dazwischen liegt, welches nicht angesteuert wird und daher keine größeren Wechselwirkungen zwischen den von den einzelnen Abstrahlelementen abgestrahlen Ultraschallwellen zu erwarten sind.

Die größten Wechselwirkungen zwischen von den Ultraschall-Abstrahlelementen abgestrahlten Ultraschallwellen treten auf, wenn räumlich überlappende Ultraschall-Abstrahlelemente auf den gegenüberliegenden Behälterwänden gleichzeitig angesteuert werden. Daher erfolgt die Ansteuerung derart, daß sich direkt gegenüberliegende bzw. teilweise überlappende Ultraschall-Abstrahlelemente auf den Seitenwänden 7 bzw. 8 nicht zur gleichen Zeit angesteuert werden. Somit wäre es z. B. denkbar, die auf der Behälterwand 8 befindlichen Ultraschall-Abstrahlelemente 20a, 20f sowie das auf der Behälterwand 7 befindliche Ultraschall-Abstrahlelement 21c gleichzeitig anzusteuern, ohne daß wesentliche Wechselwirkungen zwischen den erzeugten Ultraschallwellen auftreten würden.

Eine gleichzeitige Ansteuerung von mehreren Ultraschall-Abstrahlelementen wie bei dem obigen Beispiel ist vorteilhaft, um die in das Behandlungsfluid einzustrahlende Ultraschall-Energie und damit die Behandlungsgeschwindigkeit zu erhöhen, da mehrere Elemente angesteuert werden, ohne daß zwischen ihnen Wechselwirkungen auftreten.

Die Erfindung wurde zuvor anhand eines bevorzugten Ausführungsbeispiels beschrieben. Dem Fachmann sind jedoch Abwandlungen oder Ausgestaltungen möglich, ohne daß dadurch der Erfindunggedanken verlassen wird. Beispielsweise könnten die streifenförmigen Ultraschall-Abstrahlelemente statt vertikal wie dargestellt horizontal angeordnet sein. Ferner kann die Anzahl der Ultraschall-Abstrahlelemente je nach Bedarf verändert werden.

## Patentansprüche

1. Verfahren zum Behandeln von Substraten (12) in einem Fluidbehälter (2) mit wenigstens einem Fluid (10) und mit Ultraschall, wobei gegenüberliegende Behälterwände (7,8) jeweils wenigstens zwei Ultraschall-Abstrahlelemente (20a-20l;21a-21j) aufweisen, die jeweils einzeln angesteuert werden, **dadurch gekennzeichnet, daß** die Ultraschall-Abstrahlelemente (20a-20l;21a-21j) einer Behälterwand (7,8) in zeitlicher Beziehung zu den Ultraschall-Abstrahlelementen (21a-21j;20a-20l) der anderen Behälterwand (8,7) derart angesteuert werden, daß einander gegenüberliegende Ultraschall-Abstrahlelemente (20a-20l;21a-21j) der Behälterwände (7,8) nicht gleichzeitig angesteuert werden, um Wechselwinkungen zwischen direket auf einem der zulaufenden Ultraschallwellen zu vermeiden.

2. Verfahren nach Anspruch 1, **dadurch gekennzeichnet, daß** die Ultraschall-Abstrahlelemente (20a-20l;21a-21j) einer Behälterwand (7,8) zeitlich versetzt angesteuert werden.

3. Verfahren nach Anspruch 1 oder 2, **dadurch gekennzeichnet, daß** jedes n-te Ultraschall-Abstrahlelement (20a-20l;21a-21j) einer Behälterwand gleichzeitig angesteuert wird, wobei n ≥ 2 ist.

4. Verfahren nach einem der vorhergehenden Ansprüche, **dadurch gekennzeichnet, daß** die Substrate (12) während des Behandlüngsvorgangs relativ bezüglich der Ultraschall-Abstrahlelemente (20a-20l;21a-21j) bewegt werden.

5. Verfahren nach Anspruch 4, **dadurch gekennzeichnet, daß** die Substrate (12) während des Behandlungsvorgangs angehoben und abgesenkt werden.

## Claims

1. Method of treating substrates (12) in a fluid container (2) by at least one fluid (10) and by ultrasound, wherein oppositely disposed container walls (7, 8) each have at least two ultrasound radiation elements (20a to 20l; 21a to 21j), which are each controlled individually, **characterised in that** the ultrasound radiation elements (20a to 20l; 21a to 21j) of a container wall (7, 8) are controlled in time relationship to the ultrasound radiation elements (21a to 21j; 20a to 20l) of the other container wall (8, 7) in such a manner that mutually opposite ultrasound radiation elements (20a to 20l; 21a to 21j) of the container walls (7, 8) are not controlled simultaneously, in order to avoid mutual interactions between ultrasound waves running directly towards one another.

2. Method according to claim 1, **characterised in that** the ultrasound radiation elements (20a to 20l; 21a to 21j) of a container wall (7, 8) are controlled with an offset in time.

3. Method according to claim 1 or 2, **characterised in that** each nth ultrasound radiation element (20a to 21l; 21a to 21j) of a container wall is controlled simultaneously, wherein n is greater than or equal to 2.

4. Method according to one of the preceding claims, **characterised in that** the substrates (12) are relatively moved with respect to the ultrasound radiation elements (20a to 201; 21a to 21j) during the treatment process.

5. Method according to claim 4, **characterised in that** the substrates (14) are raised and lowered during the treatment process.

## Revendications

1. Procédé de traitement de substrats (12) dans un récipient de fluide (2) avec au moins un fluide (10) et avec des ultrasons, où des parois de récipient opposées (7, 8) présentent chacune au moins deux éléments de rayonnement d'ultrasons (20a-20l ; 21a - 21j) qui sont commandés respectivement individuellement, **caractérisé en ce que** les éléments de rayonnement d'ultrasons (20a-20l ; 21a-21j) d'une paroi de récipient (7, 8) sont commandés selon un rapport de temps aux éléments de rayonnement d'ultrasons (21a-21j ; 20a-20l) de l'autre paroi de récipient (8, 7) que des éléments de rayonnement d'ultrasons opposés l'un à l'autre (20a-20l ; 21a-21j) des parois de récipient (7, 8) ne sont pas commandés en même temps pour éviter des interactions entre des ondes ultrasonores se dirigeant directement les unes vers les autres.

2. Procédé selon la revendication 1, **caractérisé en ce que** les éléments de rayonnement d'ultrasons (20a-20l ; 21a-21j) d'une paroi de récipient (7, 8) sont commandés d'une manière décalée dans le temps.

3. Procédé selon la revendication 1 ou 2, **caractérisé en ce que** chaque n^{ième} élément de rayonnement d'ultrasons (20a-20l ; 21a-21j) d'une paroi de récipient est commandé simultanément, où n ≥ 2.

4. Procédé selon l'une des revendications précédentes, **caractérisé en ce que** les substrats (12) sont déplacés pendant l'opération de traitement relativement aux éléments de rayonnement d'ultrasons (20a-20l ; 21a-21j).

5. Procédé selon la revendication 4, **caractérisé en ce que** les substrats (12) sont relevés et abaissés pendant l'opération de traitement.
